# EUROPEAN PATENT SPECIFICATION

(11) **EP 4 600 680 B1**
(45) Date of publication and mention of the grant of the patent: **13.05.2026**
(21) Application number: 25156593.3
(22) Date of filing: 07.02.2025
(51) Int. Cl.: G01R 31/392

(54) **APPARATUS AND METHOD FOR DIAGNOSING A BATTERY**
VORRICHTUNG UND VERFAHREN ZUR DIAGNOSE EINER BATTERIE
APPAREIL ET PROCÉDÉ DE DIAGNOSTIC D'UNE BATTERIE

(30) Priority: 08.02.2024 KR 20240019805
(43) Date of publication of application: 13.08.2025
(73) Proprietor: LG Energy Solution, Ltd., Seoul 07335 (KR)
(72) Inventor: KIM, Min-Seok, 34122 Daejeon (KR); KIM, Ju-Ri, 34122 Daejeon (KR); BAE, Yoon-Jung, 34122 Daejeon (KR); JEONG, Hee-Seok, 34122 Daejeon (KR)
(74) Representative: Goddar, Heinz J.

(56) References cited:
- CN-B- 111 766 524
- US-A1- 2023 039 356
- US-A1- 2023 179 007
- ZHANG QI ET AL: "Lithium-ion battery calendar aging mechanism analysis and impedance-based State-of-Health estimation method", JOURNAL OF ENERGY STORAGE, ELSEVIER BV, NL, vol. 64, 21 March 2023 (2023-03-21), XP087298756, ISSN: 2352-152X, [retrieved on 20230321], DOI: 10.1016/J.EST.2023.107029

## Description

This application is based on and claims priority from Korean Patent Application No. 10-2024-0019805, filed on February 8, 2024, with the Korean Intellectual Property Office.

### TECHNICAL FIELD

The present disclosure relates to an apparatus and method for diagnosing a battery, and more particularly, to an apparatus and method for non-destructively diagnosing a state of a battery capable of charging and discharging.

### BACKGROUND ART

Recently, the demand for portable electronic products such as notebook computers, digital cameras and portable telephones has increased sharply, and electric vehicles, energy storage systems, robots, satellites, and the like have been developed in earnest. Accordingly, high-performance batteries allowing charging and discharging and having a high energy density are being actively studied.

Types of rechargeable batteries include lithium batteries that use lithium ions, such as lithium-ion batteries or lithium-ion polymer batteries, and nickel cadmium batteries, nickel hydrogen batteries, and nickel zinc batteries. Among these, lithium batteries have the advantages of having a relatively long lifespan, a very low self-discharge rate, and high energy density because they have almost no memory effect compared to batteries that use nickel, and thus their application range is gradually expanding.

The positive electrode and negative electrode of these batteries gradually deteriorate as the charge and discharge cycles are repeated, and they no longer maintain the electrical capacity they had at the time of manufacture but are deteriorated. Therefore, in order to accurately predict the usable time, remaining life, and replacement time of the battery, an accurate diagnosis of the battery state is required.

However, in diagnosing the battery assembly (e.g., battery module or battery pack) that includes a plurality of battery cells corresponding to the basic units of charge and discharge, the existing technologies perform diagnosis based on the SOH (State of Health) of the corresponding battery assembly. As a result, when the battery assembly includes a plurality of battery banks that are provided by connecting a plurality of battery cells in parallel with each other, the existing technologies have a problem in that they cannot diagnose the state of the corresponding battery assembly for each battery bank, and cannot diagnose whether the battery cells of each battery bank are deteriorated unevenly.

ZHANG QI ET AL: "Lithium-ion battery calendar aging mechanism analysis and impedance-based State-of-Health estimation method", JOURNAL OF ENERGY STORAGE, ELSEVIER BV, NL, vol. 64, 21 March 2023 describes Differential Voltage Analysis to explore the variation of lithium intercalation or de-intercalation processes from active materials inside batteries.

### DISCLOSURE

### Technical Problem

The present disclosure is designed to solve one or more of the problems of the related art. Therefore, some aspects of the present disclosure are directed to providing an apparatus and method for diagnosing a battery, which may diagnose the state of a battery assembly including a plurality of battery banks, which are formed by connecting a plurality of battery cells in parallel, for each battery bank, and may diagnose whether the battery cells of each battery bank are deteriorated unevenly. In the present disclosure, the battery may be a secondary battery and may also be denoted a rechargeable battery.

Another technical challenge that the present disclosure seeks to address is to provide an apparatus and method for diagnosing a battery that may extend the life of a battery assembly and improve safety.

### Technical Solution

A method for diagnosing a battery according to first aspect of the present disclosure diagnoses a battery assembly including a battery bank provided by connecting a plurality of battery cells in parallel with each other. The method comprises a differential profile generating step of generating a differential profile representing a relationship between a differential capacity and the voltage of the battery bank. The differential capacity is obtained by differentiating a capacity of the battery bank with respect to a voltage of the battery bank. The method further comprises a diagnosing step of diagnosing a state of the battery bank based on a difference value between a differential capacity value of a target peak located in a predetermined voltage section among a plurality of peaks of the differential profile and a differential capacity value of a valley adjacent to the target peak. The differential profile is also denoted differential battery bank profile in the following.

In an embodiment, the differential profile generating step may include a step of repeatedly measuring a voltage value and a current value of the battery bank using at least one electrical sensor. The measurements may be performed while the battery bank is being charged or discharged. The differential profile generating step may further include a step of generating the differential battery bank profile using the voltage values and the current values measured (e.g., the voltage values and the current values measured while the battery bank is being charged or discharged).

In an embodiment, the differential profile generating step may include a step of generating a profile representing the relationship between the voltage and the capacity of the battery bank; and a step of generating the differential profile by differentiating the profile with respect to the voltage of the battery bank.

In an embodiment, the diagnosing step may include a step of diagnosing the state of the battery bank as an abnormal state when the difference value is less than a predetermined reference value.

In an embodiment, the diagnosing step may include a step of diagnosing the state of the battery bank as an abnormal state in which the plurality of battery cells are unevenly deteriorated, when the difference value is less than a predetermined reference value and the number of target peaks located in the predetermined voltage section exceeds a predetermined reference number.

In an embodiment, the diagnosing step may include a step of determining or calculating a first difference value between a differential capacity value of a first target peak located in a first voltage section among the predetermined voltage sections and a differential capacity value of a first valley adjacent to the first target peak; a step of calculating a second difference value between a differential capacity value of a second target peak located in a second voltage section among the predetermined voltage sections and a differential capacity value of a second valley adjacent to the second target peak; and a step of determining the state of the battery bank as an abnormal state in which the plurality of battery cells are unevenly deteriorated, when the first difference value is less than a predetermined first reference value and the second difference value is less than a predetermined second reference value.

In an embodiment, the battery assembly may include a plurality of battery banks, the differential profile generating step may include a step of generating a plurality of differential profiles respectively corresponding to the plurality of battery banks, and the diagnosing step may include a step of diagnosing a state of each of the plurality of battery banks as a normal state or an abnormal state based on the plurality of differential profiles.

In an embodiment, the diagnosing step may include a step of diagnosing the state of the battery bank as an abnormal state when the difference value is less than a predetermined reference value, and the method for diagnosing a battery may further comprise a step of controlling a charger that charges the battery bank to reduce a voltage at an end of charging of the battery bank or reduce a current rate of a current that charges the battery bank, when the state of the battery bank is diagnosed as an abnormal state.

An apparatus for diagnosing a battery according to another aspect of the present disclosure diagnoses a battery assembly including a battery bank provided by connecting a plurality of battery cells in parallel with each other, and the apparatus comprises a differential profile generating unit configured to generate a differential profile representing a relationship between a differential capacity, which is obtained by differentiating a capacity of the battery bank with respect to a voltage of the battery bank, and the voltage of the battery bank; and a diagnosing unit configured to diagnose a state of the battery bank based on a difference value between a differential capacity value of a target peak located in a predetermined voltage section among a plurality of peaks of the differential profile and a differential capacity value of a valley adjacent to the target peak.

In an embodiment, the diagnosing unit may be configured to diagnose the state of the battery bank as an abnormal state when the difference value is less than a predetermined reference value.

In an embodiment, the diagnosing unit may include a calculation module configured to calculate a first difference value between a differential capacity value of a first target peak located in a first voltage section among the predetermined voltage sections and a differential capacity value of a first valley adjacent to the first target peak and calculate a second difference value between a differential capacity value of a second target peak located in a second voltage section among the predetermined voltage sections and a differential capacity value of a second valley adjacent to the second target peak; and a determination module configured to determine the state of the battery bank as an abnormal state in which the plurality of battery cells are unevenly deteriorated, when the first difference value is less than a predetermined first reference value and the second difference value is less than a predetermined second reference value.

In an embodiment, the battery assembly may include a plurality of battery banks, the differential profile generating unit may be configured to generate a plurality of differential profiles respectively corresponding to the plurality of battery banks, and the diagnosing unit may be configured to diagnose a state of each of the plurality of battery banks as a normal state or an abnormal state based on the plurality of differential profiles.

In an embodiment, the diagnosing unit may be configured to diagnose the state of the battery bank as an abnormal state when the difference value is less than a predetermined reference value, and the apparatus for diagnosing a battery may further comprise a battery management unit configured to control a charger that charges the battery bank to reduce a voltage at an end of charging of the battery bank or reduce a current rate of a current that charges the battery bank, when the state of the battery bank is diagnosed as an abnormal state.

A battery pack according to a third aspect of the present disclosure may comprise the apparatus for diagnosing a battery as described above in connection with the second aspect.

A vehicle according to a fourth aspect of the present disclosure may comprise the apparatus for diagnosing a battery as described above in connection with the second aspect.

One or more computer readable media according to a fifth aspect of the present disclosure may store instructions that, when executed by one or more processing units (e.g. provided in an apparatus for diagnosing a battery), cause the one or more processing units to diagnose a battery assembly including a battery bank provided by connecting a plurality of battery cells in parallel with each other, by performing a differential battery bank profile generating step of generating a differential battery bank profile representing a relationship between a differential capacity and the voltage of the battery bank; and a diagnosing step of diagnosing a state of the battery bank based on a difference value between a differential capacity value of a target peak located in a predetermined voltage section among a plurality of peaks of the differential battery bank profile and a differential capacity value of a valley adjacent to the target peak.

The one or more computer readable media may further store instructions that, when executed by the one or more processing units, may cause the one or more processing units to perform the steps of the method according to one of the embodiments of the first aspect of the present disclosure.

A computer program according to a sixths aspect of the present disclosure, when executed by one or more processing units, cause the one or more processing units (e.g. provided in an apparatus for diagnosing a battery) to diagnose a battery assembly including a battery bank provided by connecting a plurality of battery cells in parallel with each other, by performing a differential battery bank profile generating step of generating a differential battery bank profile representing a relationship between a differential capacity and the voltage of the battery bank; and a diagnosing step of diagnosing a state of the battery bank based on a difference value between a differential capacity value of a target peak located in a predetermined voltage section among a plurality of peaks of the differential battery bank profile and a differential capacity value of a valley adjacent to the target peak..

The computer program, when executed by the one or more processing units, may cause the one or more processing units to perform the steps of the method according to one of the embodiments of the first aspect of the present disclosure.

### Advantageous Effects

The present disclosure diagnoses the state of the battery bank by using the differential profile (also denoted differential battery bank profile), which represents the relationship between the differential capacity and the voltage of the battery bank, thereby enabling the diagnosis of the state of the battery assembly including a plurality of battery banks for each battery bank, and improving the accuracy and reliability of the diagnosis result.

In addition, the present disclosure may accurately diagnose whether the battery cells are deteriorated unevenly in a battery bank that is formed by connecting the battery cells in parallel by diagnosing the state of the battery bank based on the difference value between the differential capacity value of a target peak located in a predetermined voltage section among a plurality of peaks of the differential battery bank profile and the differential capacity value of a valley adjacent to the target peak.

In addition, the present disclosure may perform management of a battery assembly including a plurality of battery banks for each battery bank by controlling the charge and/or discharge conditions of the corresponding battery bank according to the diagnosis result of the battery bank, thereby extending the life of the entire battery assembly and improving safety.

Furthermore, a person having ordinary skill in the art to which the present disclosure belongs will be able to clearly understand from the following description that various embodiments according to the present disclosure can solve various technical problems not mentioned above.

### DESCRIPTION OF DRAWINGS

FIG. 1 is a block diagram showing an apparatus for diagnosing a battery according to an embodiment of the present disclosure.
FIG. 2 is a drawing showing an example of a battery assembly to be diagnosed according to the present disclosure.
FIG. 3 is a drawing showing an example of a battery bank profile showing the correspondence relationship between the capacity and voltage of a battery bank.
FIG. 4 is a drawing showing a differential battery bank profile of a normal battery bank.
FIG. 5 is a drawing showing the differential battery bank profile of a battery bank that is being deteriorated unevenly.
FIG. 6 is a drawing showing a differential battery bank profile of an abnormal battery bank.
FIG. 7 is a graph showing the trend of a differential capacity difference value between a first target peak and a first valley, as shown in FIG. 4, changing over time.
FIG. 8 is a graph showing the trend of a differential capacity difference value between a second target peak and a second valley, as shown in FIG. 4, changing over time.
FIG. 9 is a flow chart showing a method for diagnosing a battery according to an embodiment of the present disclosure.
FIG. 10 is a drawing showing a battery pack according to an embodiment of the present disclosure.
FIG. 11 is a drawing showing a vehicle according to an embodiment of the present disclosure.

### DETAILED DESCRIPTION

Hereinafter, in order to clarify the solution corresponding to the technical challenge of the present disclosure, exemplary embodiments according to different aspects of the present disclosure will be described in detail with reference to the attached drawings. However, when explaining the present disclosure, if a description of a related publicly known technology obscures the gist of the present disclosure, the description thereof may be omitted. In addition, the terms used in this specification are terms defined in consideration of the functions in the present disclosure, and these may vary depending on the intention or custom of the designer, manufacturer, etc. Therefore, the definitions of the terms described below should be made based on the contents throughout this specification.

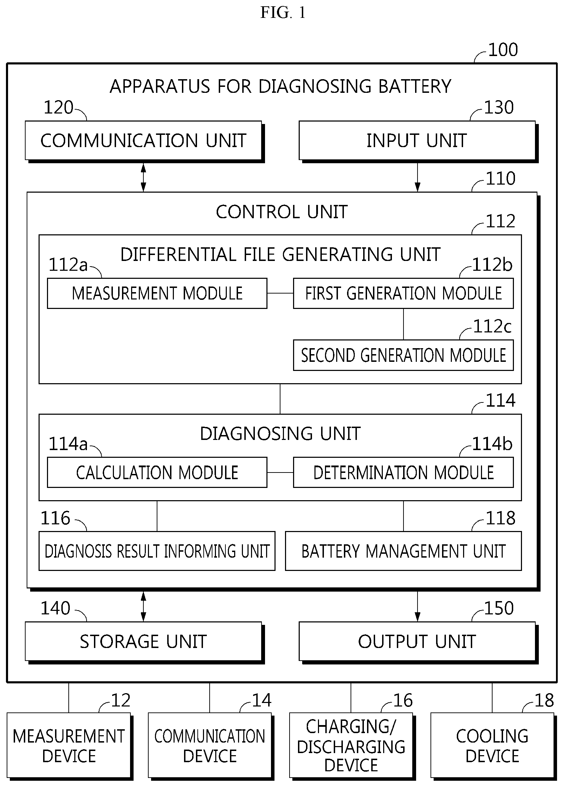

FIG. 1 is a block diagram showing an apparatus 100 for diagnosing a battery (also referred to as a diagnostic apparatus or device) according to an embodiment of the present disclosure.

As illustrated in FIG. 1, the apparatus 100 for diagnosing a battery according to an embodiment of the present disclosure includes a control unit 110. The apparatus 100 for diagnosing a battery is denoted battery diagnosis apparatus 100 in the following. The control unit 110 is configured to non-destructively diagnose a battery assembly. The battery assembly may include one or more battery banks. Each battery bank may be formed by connecting a plurality of rechargeable battery cells in parallel.

To this end, the control unit 110 may include one or more general-purpose processors or ASICs (application-specific integrated circuits) - which may be also denoted processing units - for executing the battery diagnosis logic and may optionally further include hardware such as registers and memories according to an embodiment. The control unit 110 may be configured with a combination of hardware such as a processor and software such as a computer program. That is, the battery diagnosis logic of the control unit 110 may be configured as a computer program and stored in the memory of the control unit 110 or a storage unit 140 described below, and the stored computer program may be configured to be executed through the hardware of the control unit 110.

Meanwhile, the control unit 110 is a detailed component for diagnosing the battery assembly and includes a differential profile generating unit 112 and a diagnosing unit 114.

The differential profile generating unit 112 is configured to generate a differential profile. The differential profile may represent the correspondence relationship between the differential capacity and the voltage of a battery bank. Therefore, the differential profile may also be referred to as a differential battery bank profile in the present disclosure. The differential capacity dQ/dV may be obtained, for example, by differentiating the capacity Q of the battery bank included in a battery assembly with respect to the voltage V of the battery bank. In some embodiments, the differential capacity dQ/dV may be obtained by differentiating a battery bank profile representing a correspondence relationship between the capacity Q and voltage V of the battery bank with respect to the voltage.

The capacity of the battery bank may be derived from the voltage V and/or current I measurements of a measurement unit, such as the measurement module 112a. The measurements may be performed in a charging and/or discharging cycle of the battery bank. In some example implementations, the capacity Q of the battery bank may be determined based on the current measurements using Coulomb counting. For example, the differential profile generating unit 112 or the measurement module 112 may integrate the current measurements over time to estimate the capacity Q of the battery bank. Optionally, the capacity Q of the battery bank may be adjusted to consider internal resistance, polarization, and electrochemical effects of the battery bank. Such adjustments or corrections may be based on the voltage measurements, e.g., measurements of the terminal voltage and/or open circuit voltage (OCV).

The differential battery bank profile may be, for example, a data structure that interrelates (or corelates) respective values of the differential capacity dQ/dV of a battery bank to corresponding values of the voltage V of the battery bank for the respective values of the differential capacity dQ/dV (or vice versa). The differential battery bank profile may be determined in a charging and/or discharging process of the battery bank. The differential battery bank profile may for example represented in a two-dimensional data array. In some embodiments, the differential battery bank profile may be representable as a two-dimensional differential battery bank profile, where one axis of the differential battery bank profile (e.g. the X-axis) denotes values of the voltage V of the battery bank and another axis of the differential battery bank profile (e.g. the Y-axis) denotes values of the differential capacity dQ/dV of a battery bank that correspond to the respective values of the voltage V of the battery bank.

The number of pairs of differential capacity values of the differential capacity dQ/dV of the battery bank and corresponding voltage values of the voltage V of the battery bank in the differential battery bank profile may be determined by the number of measurements. Optionally, interpolation may be used to generate intermediate pairs of differential capacity values of the differential capacity dQ/dV of the battery bank and corresponding values of the voltage V of the battery bank in the differential battery bank profile from the measurement-based pairs of values of the differential capacity dQ/dV of the battery bank and the corresponding values of the measured voltage V of the battery bank in the differential battery bank profile. As noted, individual pairs of differential capacity values of the differential capacity dQ/dV and the corresponding voltage values of the voltage V of the battery bank may be obtained in a charging and/or discharging process of the battery bank. The individual pairs of values of differential capacity values of the differential capacity dQ/dV and corresponding values of the of the voltage V of the battery bank may be obtained in a charging and/or discharging process of the battery bank in intervals, such as, for example, predetermined or configurable time intervals.

The measured voltage V may be a terminal voltage of the battery bank. The terminal voltage may be measured across the terminals of the battery bank while the battery bank is powering a load/discharging or while the battery is being charged. In this case, the interval between measurements for generating respective pairs of the differential capacity dQ/dV and voltage V may be a predetermined or configurable time interval.

In an embodiment, the differential profile generating unit 112 may include a measurement module 112a, a first profile generation module 112b (also denoted first generation module 112b), and a second profile generation module 112c (also denoted second generation module 112c).

In this case, the measurement module 112a may be configured to repeatedly measure the voltage value and current value of the battery bank using at least one electrical sensor. The measurement module 112a may perform the measurements in a charging cycle and/or discharging cycle, i.e., while the battery bank is charged or discharged. The measurement module 112a may be configured to measure the voltage and current of the battery bank across the positive terminal and the negative terminal of the battery bank. The measured voltage may be the terminal voltage of the battery bank that is measured in a charging cycle and/or discharging cycle of the battery bank. This way, the measured voltage may include effects of internal resistance of the battery bank and electrochemical reactions occurring under load conditions.

In some embodiments, the measurement module 112a may measure the voltage value and current value of the battery bank in predetermined or configurable time intervals. The time intervals may also be set based on the (current) charge/discharge rate (e.g., C-rate) and/or voltage dynamics of the battery bank. The time interval for the measurements may be, for example, in the range from 100 ms (inclusive) to 60 s (inclusive). However, the present disclosure is not limited to this range. In general, the time interval for the voltage and current measurements may be based on the C-rate and/or voltage dynamics of the battery bank. For example, shorter measurement intervals (e.g., 100 ms to 1s) may be suitable for fast charging/discharging (≥ 1C), while intermediate measurement intervals (e.g., 1s to 10s) may be suitable for medium-rate charging/discharging (0.1C-1C). Longer measurement intervals (e.g., 10s to 60s) might be used for low-rate applications (<0.1C).

The one or more electrical sensors of the measurement module 112a may include a voltage sensor configured to measure the voltage across the positive terminal and the negative terminal of the battery bank. The one or more electrical sensors of the measurement module 112a may (further) include a current sensor configured to measure the current flowing, for example, into the positive terminal or the negative terminal of the battery bank. The current sensor may be implemented, for example, as a shunt resistor, a hall effect sensor, or a fluxgate sensor, which can be used for direct current and alternating current measurement. However, the disclosure is not limited to these examples of a current sensor.

The first profile generation module 112b and the second profile generation module 112c may generate the differential battery bank profile using the voltage values V and current values I measured by the measurement module 112a while the battery bank is being charged and/or discharged.

For example, the first profile generation module 112b may be configured to generate a battery bank profile representing the correspondence relationship between the voltage V and capacity Q of the battery bank using voltage values and current values measured while the battery bank is being charged or discharged. As noted, the first profile generation module 112b may be configured to implement Coulomb counting to estimate the capacity Q of the battery bank based on the current measurements and may optionally further consider voltage measurements to consider internal resistance, polarization, and electrochemical effects of the battery bank.

The battery bank profile may be, for example, a data structure that interrelates (or corelates) respective values of the capacity Q of a battery bank to corresponding values of the voltage V of the battery bank for the respective values of the capacity Q (or vice versa). The battery bank profile may be determined in a charging and/or discharging process of the battery bank. The battery bank profile may for example represented in a two-dimensional data array. In some embodiments, the battery bank profile may be representable as a two-dimensional battery bank profile, where one axis of the battery bank profile (e.g. the X-axis) denotes values of the voltage V of the battery bank and another axis of the battery bank profile (e.g. the Y-axis) denotes values of the capacity Q of a battery bank that correspond to the respective values of the voltage V of the battery bank.

The number of pairs of capacity values of the capacity Q of the battery bank and corresponding voltage values of the voltage V of the battery bank in the battery bank profile may be determined by the number of measurements. Optionally, interpolation may be used to generate intermediate pairs of capacity values of the capacity Q of the battery bank and corresponding values of the voltage V of the battery bank in the battery bank profile from the measurement-based pairs of values of the capacity Q of the battery bank and the corresponding values of the measured voltage V of the battery bank in the battery bank profile. As noted, individual pairs of capacity values of the capacity Q and the corresponding voltage values of the voltage V of the battery bank may be obtained in a charging and/or discharging process of the battery bank. The individual pairs of values of capacity values of the capacity Q and corresponding values of the of the voltage V of the battery bank may be obtained in a charging and/or discharging process of the battery bank in intervals, such as, for example, predetermined or configurable time intervals.

The measured voltage V may be a terminal voltage of the battery bank. The terminal voltage may be measured across the terminals of the battery bank while the battery bank is powering a load/discharging or while the battery is being charged. In this case, the interval between measurements for generating respective pairs of the capacity Q and voltage V may be a predetermined or configurable time interval.

The second profile generation module 112c may be configured to generate the differential battery bank profile by differentiating the generated battery bank profile with respect to the voltage of the battery bank.

The diagnosing unit 114 is configured to diagnose the state of the battery bank based on a difference value between the differential capacity value of a target peak located in a predetermined voltage section among a plurality of peaks of the differential battery bank profile and the differential capacity value of a valley adjacent to the target peak. In some embodiments, the target peak and the valley adjacent to the target peak in the differential profile of the battery bank may be in the predetermined voltage section. The valley adjacent to the target peak in the differential profile may be considered a minimum of the differential profile of the battery bank that is neighboring or adjacent to the target peak. The target peak mal be a maximum of the differential profile of the battery bank in the predetermined voltage section.

The voltage section where the target peak is located may be determined experimentally. That is, the voltage section where the peak among the peaks of the differential battery bank profile is located may be experimentally confirmed, and the confirmed voltage section may be determined as the voltage section where the target peak is located. The peak may be a peak where splitting occurs, e.g. due to uneven deterioration of the battery bank.

The splitting phenomenon may for example refer to the occurrence of multiple peaks in the differential profile of a battery bank. In a healthy battery bank, the differential profile of the battery bank typically exhibits distinct single peaks at specific voltage levels. The specific voltage levels may be located within one or more voltage sections or ranges of the differential profile. However, as the battery bank, i.e., the battery cells thereof, age(s) or undergo(es) uneven deterioration, these peaks may split into multiple peaks, which may be an indication that different battery cells within the battery bank are no longer charging or discharging uniformly. This splitting phenomenon may occur due to several factors, including uneven degradation among battery cells, but also other factors, such as loss of lithium inventory, changes in internal resistance, and structural modifications within the electrodes may influence the peak splitting.

The diagnosing unit 114 may be configured to detect peak splitting by analyzing changes in the differential profile of the battery bank over time. If the difference between a target peak in a voltage section and its adjacent/neighboring valley falls below a predetermined threshold, the diagnosing unit 114 may identify the battery bank as abnormal. By monitoring the evolution of the differential profile of a battery bank, it may thus become possible to detect early signs of battery bank degradation and cell imbalance, allowing for optimized charging and maintenance strategies to extend the battery bank's lifespan and prevent failures. The one or more voltage sections in which the peak splitting phenomenon may be monitored by the diagnosing unit 114 can be determined, for example, experimentally. The voltage sections may thus be predefined and may be, for example, based on known electrochemical characteristics of the battery cells or battery bank. The voltage sections may for example correspond to voltage range(s) where phase transitions in the battery cells' electrodes may occur, where differential capacity peaks occur naturally.

In an embodiment, the diagnosing unit 114 may be configured to diagnose the state of the battery bank as an abnormal state if the difference value between the differential capacity value of the target peak located in a predetermined voltage section among a plurality of peaks of the differential profile of the battery bank and the differential capacity value of a valley (or minimum) in the differential profile that is adjacent to the target peak is less than a predetermined reference value. The valley (or minimum) in the differential profile that is adjacent to the target peak may be a valley (or minimum) in the differential profile that is directly adjacent or neighboring the target peak. In this case, the abnormal state may denote a state in which a plurality of battery cells forming the battery bank are unevenly deteriorated.

The reference value may be a difference value between a differential capacity value of a target peak and a differential capacity value of a neighboring valley detected in a differential battery bank reference profile, or a difference value determined during the design of the battery assembly. In some embodiments, the differential battery bank reference profile is a differential profile of the battery bank generated at the BOL (Beginning of Life) of the battery bank.

In another embodiment, the diagnosing unit 114 may be configured to diagnose the state of the battery bank as an abnormal state if the difference value between the differential capacity value of the target peak located in a predetermined voltage section among a plurality of peaks of the differential profile of the battery bank and the differential capacity value of a valley (or minimum) in the differential profile that is adjacent to the target peak is less than a predetermined reference value and the number of target peaks located in the predetermined voltage section exceeds a predetermined reference number. For example, the diagnosing unit 114 may be configured to diagnose the state of the battery bank as an abnormal state if the difference value between the differential capacity value of the target peak located in a predetermined voltage section among a plurality of peaks of the differential profile of the battery bank and the differential capacity value of a valley (or minimum) in the differential profile that is adjacent to the target peak is less than the predetermined reference value and there is more than one target peak located in the predetermined voltage section. In this case, the abnormal state may mean a state in which the plurality of battery cells of the battery bank are unevenly deteriorated.

In an embodiment, the diagnosing unit 114 may include a calculation module 114a and a determination module 114b.

In this case, the calculation module 114a may be configured to calculate the difference value between a differential capacity value of a target peak located in the predetermined voltage section and a differential capacity value of a first valley adjacent to the target peak.

The determination module 114b may be configured to determine the state of the battery bank as an abnormal state in which a plurality of battery cells of the battery bank are unevenly deteriorated, if the difference value between the differential capacity value of the target peak located in the predetermined voltage section and the differential capacity value of the first valley adjacent to the target peak is less than a predetermined reference value.

In another embodiment, the diagnosing unit 114 may be configured to determine the state of the battery bank based on a plurality of target peaks. The target peaks considered by the diagnosing unit 114 may be located in respective voltage sections of the differential battery bank profile.

In this case, the calculation module 114a may be configured to calculate a first difference value between a differential capacity value of a first target peak located in a first voltage section among the predetermined voltage sections and a differential capacity value of a first valley adjacent to the first target peak, and to calculate a second difference value between a differential capacity value of a second target peak located in a second voltage section among the predetermined voltage sections and a differential capacity value of a second valley adjacent to the second target peak.

The determination module 114b may be configured to determine the state of the battery bank as an abnormal state in which a plurality of battery cells of the battery bank are unevenly deteriorated, if the first difference value is less than a predetermined first reference value and/or the second difference value is less than a predetermined second reference value.

In an embodiment, when the battery assembly to be diagnosed includes a plurality of battery banks, the differential profile generating unit 112 may be configured to generate a plurality of differential battery bank profiles corresponding to the plurality of battery banks, respectively. The differential profile generating unit 112 may be configured to generate a differential battery bank profile for each battery bank of the battery assembly.

In addition, the diagnosing unit 114 may be configured to diagnose the state of each of the plurality of battery banks as a normal state or an abnormal state based on the plurality of differential battery bank profiles, as described herein above.

In an embodiment, the control unit 110 may further include a diagnosis result informing unit 116. In this case, the diagnosis result informing unit 116 may be configured to output a visual, auditory or audio-visual notification signal corresponding to the diagnosis result of the battery bank using a predetermined output device.

In an embodiment, the control unit 110 may further include a battery management unit 118. In this case, the battery management unit 118 may be configured to control a charging condition and/or a discharging condition of the one or more battery banks according to the diagnosis result of the diagnosing unit 114.

For example, according to the diagnosis result of the diagnosing unit 114, when an abnormal battery bank is detected among the plurality of battery banks included in the battery assembly, the battery management unit 118 may be configured to control a charger (e.g. charging/discharging device 16) that charges the abnormal battery bank to reduce a voltage at the end of charging of the abnormal battery bank or reduce a current rate of a current that charges the abnormal battery bank.

Meanwhile, the battery management unit 118 may be configured to control the cooling device 18 described later to lower the temperature of an abnormal battery bank.

The differential profile generating unit 112, the diagnosing unit 114, the diagnosis result informing unit 116, and the battery management unit 118 of the above-described control unit 110 may be implemented as a combination of a processor and a program executed by the processor. In this case, the control unit 110 may be implemented as a single processor, or may be implemented as two or more processors that are interconnected. The program may be stored in form of instructions on one or more computer readable media (e.g., storage unit 140) accessible by the processor for execution.

In an embodiment, the battery diagnosis apparatus 100 may further include a communication unit 120. The communication unit 120 may be configured to receive data transmitted from a remotely located server or communication terminal via a wired and/or wireless communication network and transmit the data to the control unit 110, or transmit control signals, diagnostic data, etc. processed by the control unit 110 to the remotely located server or communication terminal. To this end, the communication unit 120 may include a communication modem that performs wired and/or wireless communication.

In an embodiment, the battery diagnosis apparatus 100 may further include an input unit 130. The input unit 130 may be configured to receive commands or data from a user or an administrator. For this purpose, the input unit 130 may include an input device such as a keyboard, operating buttons, or a touch panel.

In an embodiment, the battery diagnosis apparatus 100 may further include a storage unit 140. The storage unit 140 may be configured to store and manage data required for the operation of the battery diagnosis apparatus 100. To this end, the storage unit 140 may include one or two or more of a ROM, a RAM, an EEPROM, a register, a flash memory, a CD-ROM, a magnetic tape, a hard disk, a floppy disk, and an optical data recording device.

In an embodiment, the battery diagnosis apparatus 100 may further include an output unit 150. The output unit 150 may be configured to visually, audibly or audiovisually output a notification signal of the diagnosis result informing unit 116. For this purpose, the output unit 150 may include a visual output device such as a light-emitting diode, a monitor, a display panel or a touch screen. In addition, the output unit 150 may further include a sound generating device such as a speaker.

In an embodiment, the battery diagnosis apparatus 100 may be configured to be interlocked with or connected to a measurement device 12 for measuring voltage and/or current of a battery assembly to be diagnosed, a communication device 14 for communicating with another device, a charging/discharging device 16 for charging and discharging battery banks included in the battery assembly, a cooling device 18 for cooling the battery banks included in the battery assembly, etc.

In another embodiment, the battery diagnosis apparatus 100 according to the present disclosure may include one or more of the measurement devices 12, the communication device 14, the charging/discharging device 16, and the cooling device 18 described above.

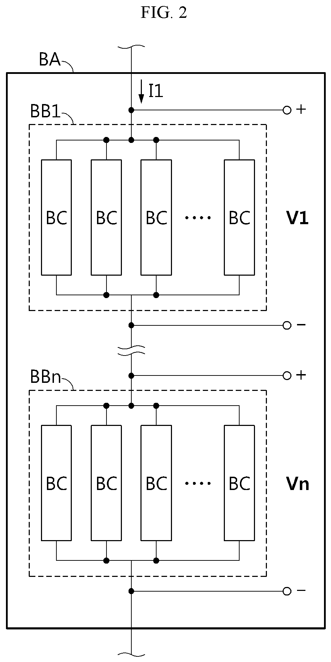

FIG. 2 is a drawing showing an example of a battery assembly BA that is to be diagnosed in accordance with the present disclosure.

As illustrated in FIG. 2, the battery assembly BA, which is the diagnostic target of the present disclosure, may include a plurality of battery banks BB1 to BBn. In the example of FIG. 2, the plurality of battery banks BB1 to BBn may be connected in series with each other. Alternatively, the plurality of battery banks BB1 to BBn may be connected in a manner that mixes serial and parallel connections of the battery banks BB1 to BBn. In addition, each battery bank may include a plurality of battery cells BC that are connected to each other in parallel.

Such a battery assembly BA may be implemented as a battery module or a battery pack including battery banks and a case that accommodates the battery banks.

Since the plurality of battery cells BC included in each battery bank are connected in parallel with each other, it is difficult to measure the voltage of each battery cell. Therefore, the existing technology that estimates the State of Charge (SOC) or State of Health (SOH) of the battery assembly by using the voltage, current, temperature, etc. of the entire battery assembly as parameters cannot diagnose the state of the battery assembly for each battery bank, and cannot determine whether the battery cells of the above-mentioned battery bank are deteriorated unevenly.

On the other hand, the battery diagnosis apparatus 100 according to the present disclosure measures the voltage (V1) and current (I1) of the battery bank BB1 while the battery bank BB1 is being charged or discharged, generates a battery bank profile representing the correspondence relationship between the voltage and capacity of the battery bank BB1, and uses a differential battery bank profile obtained by differentiating this battery bank profile to diagnose the state of the battery bank, thereby making it possible to diagnose the state of the battery assembly for each battery bank and accurately determine whether the battery cells of the battery bank are deteriorated unevenly.

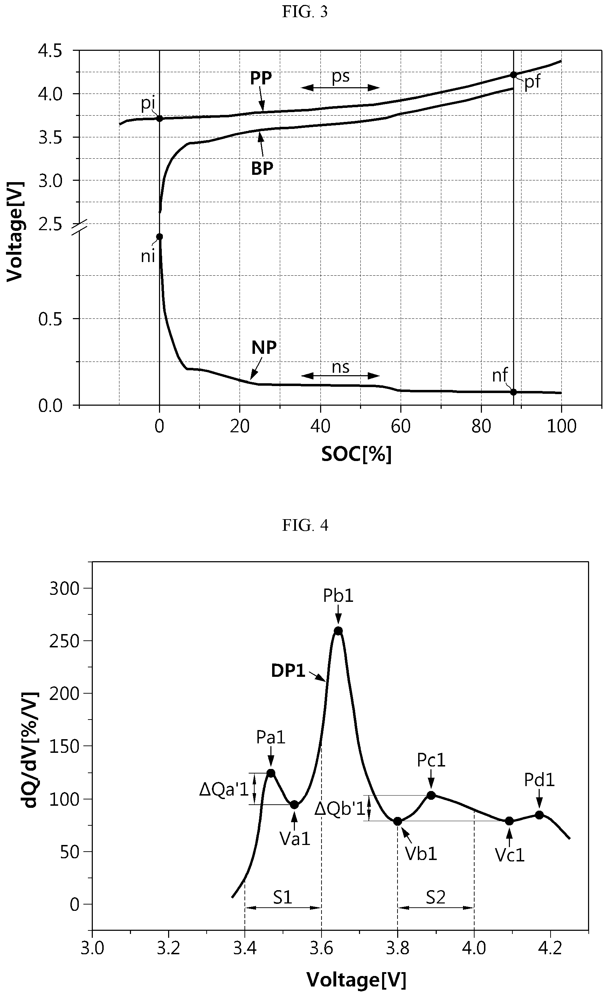

FIG. 3 is a drawing showing an example of a profile showing the correspondence relationship between the capacity and voltage of a battery bank. This profile is also denoted battery bank profile in the present disclosure.

As illustrated in FIG. 3, the differential profile generating unit 112 may generate a battery bank profile BP representing a correspondence relationship between the capacity and voltage of a battery bank, e.g., battery bank BB1. The differential profile generating unit 112 may generate the battery bank profile BP by measuring electrical values (V1, I1) of the battery bank BB1 while the battery bank BB1 of FIG. 2 is being charged or discharged. In the example in FIG. 3, the capacity of the battery bank is expressed as a SOC value. For example, the capacity Q of the battery bank BB1 may be calculated by applying a current integration method to the current (I1) that charges or discharges the battery bank BB1. In some embodiments, the capacity Q of the battery bank BB1 may be considered representing an absolute charge measurement of the battery bank BB1 or the current capacity of the battery bank BB1. The SOC may represent a relative percentage value that expresses the capacity Q in relation to the full capacity Qmax of the battery bank BB1. The SOC may thus indicate how much energy is available at a given moment. As noted, the SOC may be for example determined using Coulomb counting/current integration, but in general, also a voltage-based estimation, or model-based methods may be used to determine the SOC.

Meanwhile, the differential profile generating unit 112 may determine a positive electrode profile PP and a negative electrode profile NP which generate a curve similar to the profile BP by mutual combination, and provide the start point (pi) and the end point (pf) of the positive electrode profile PP, the shrinkage ratio (ps) of the positive electrode profile PP compared with a reference positive electrode profile, the start point (ni) and the end point (nf) of the negative electrode profile NP, the shrinkage ratio (ns) of the negative electrode profile NP compared with a reference negative electrode profile, etc., to the diagnosing unit 114. In some example embodiments, the differential profile generating unit 112 may be configured to determine the battery bank profile BP by subtracting the negative electrode profile NP from the positive electrode profile PP.

The diagnosing unit 114 may use the start point (pi), the end point (pf) and the shrinkage ratio (ps) of the positive electrode profile PP, and the start point (ni), the end point (nf) and the shrinkage ratio (ns) of the negative electrode profile NP as diagnostic factors indicating the state of the battery bank BB1.

In addition, the differential profile generating unit 112 may generate the differential battery bank profile by differentiating the battery bank profile BP with respect to the voltage of the battery.

In some example embodiments, the differential profile generating unit 112 may directly determine the battery bank profile BP and may provide the battery bank profile BP, the start point and the end point of the battery bank profile BP and shrinkage ratio the battery bank profile BP compared with a reference battery bank profile, etc., to the diagnosing unit 114.

The diagnosing unit 114 may use the start point, the end point and the shrinkage ratio of the battery bank profile BP as diagnostic factors indicating the state of the battery bank BB1.

In addition, the differential profile generating unit 112 may generate the differential battery bank profile by differentiating the battery bank profile BP with respect to the voltage of the battery.

FIG. 4 is a drawing showing a differential battery bank profile DP1 of a normal battery bank.

As illustrated in FIG. 4, the differential profile generating unit 112 may generate, for each battery bank, a differential battery bank profile DP1 that represents a correspondence relationship between a differential capacity (dQ/dV), which is obtained by differentiating the capacity of the battery bank with respect to the voltage of the battery bank, and the voltage of the battery bank at a predetermined diagnostic cycle.

In this case, the measurement module 112a of the differential profile generating unit 112 may repeatedly measure (e.g., in predetermined or configurable time intervals) the voltage value and current value of a battery bank using at least one electrical sensor while the battery bank is being charged or discharged.

Then, the first profile generation module 112b and the second profile generation module 112c of the differential profile generating unit 112 may generate the differential battery bank profile DP1 using the voltage values and current values measured by the measurement module 112a while the battery bank is being charged or discharged.

For example, the first profile generation module 112b may generate a battery bank profile BP representing a correspondence relationship between the voltage and capacity of the battery bank using the voltage values and current values measured while the battery bank is being charged or discharged.

Next, the second profile generation module 112c may generate the differential battery bank profile DP1 by differentiating the generated battery bank profile BP with respect to the voltage of the battery bank.

The diagnosing unit 114 may diagnose the state of the battery bank based on the difference value (ΔQa'1) between the differential capacity value of a target peak (Pa1) located in a predetermined voltage section (S1) among a plurality of peaks (Pa1, Pb1, Pc1, Pd1) of the differential battery bank profile DP1 and the differential capacity value of a valley (Va1) adjacent to the target peak (Pa1). The voltage section may also be referred to as a voltage range. As shown in the example of FIG. 4, the voltage section (S1) may be a range from 3.4 [V] to 3.6 [V]. However, the voltage section (S1) is not limited to this range. For example, the voltage section may also be a range where the voltage is equal to or smaller than 3.6 [V], or a range from 3.2 [V] to 3.6 [V], or a range 3.3 [V] to 3.6 [V], or the like.

For example, if the difference value (ΔQa'1) is less than a predetermined reference value, the diagnosing unit 114 may be configured to diagnose the state of the battery bank as an abnormal state. In this case, the abnormal state may mean a state in which a plurality of battery cells forming the battery bank are unevenly deteriorated.

The reference value may be a difference value between a differential capacity of a target peak and a differential capacity of a neighboring valley detected from a reference differential battery bank profile, or a difference value determined during the design of the battery assembly. In some embodiments, the reference differential battery bank profile may be a differential battery bank profile generated at the BOL (Beginning of Life) point of the battery bank. The target peak of the reference differential battery bank profile may be, for example, a (local) maximum of the reference differential battery bank profile. The valley of the reference differential battery bank profile may be, for example, a (local) minimum of the reference differential battery bank profile.

In another embodiment, the diagnosing unit 114 may be configured to determine the state of the battery bank based on a plurality of target peaks. The target peaks may be located in different voltage sections of the reference differential battery bank profile.

In this case, the calculation module 114a of the diagnosing unit 114 may be configured to calculate a first difference value (ΔQa'1) between a differential capacity value of a first target peak (Pa1) located in a first voltage section (S1) of a predetermined voltage section and a differential capacity value of a first valley (Va1) adjacent to the first target peak (Pa1), and to calculate a second difference value (ΔQb'1) between a differential capacity value of a second target peak (Pc1) located in a second voltage section (S2) of the predetermined voltage section and a differential capacity value of a second valley (Vb1) adjacent to the second target peak (Pc1). The first voltage section (S1) may be a section from 3.4 [V] to 3.6 [V], and the second voltage section (S2) may be a section from 3.8 [V] to 4.0 [V]. However, the first voltage section (S1) and the second voltage section (S2) are not limited to these ranges. For example, the first voltage section (S1) may also be a range where the voltage is equal to or smaller than 3.6 [V], or a range from 3.2 [V] to 3.6 [V], or a range 3.3 [V] to 3.6 [V], or the like. For example, the second voltage section (S1) may also be a range where the voltage is equal to or higher than 3.8 [V], or a range from 3.8 [V] to 4.1 [V], or a range 3.8[V] to 4.2 [V], or the like.

Then, the determination module 114b of the diagnosing unit 114 may determine the state of the battery bank as an abnormal state in which a plurality of battery cells of the battery bank are unevenly deteriorated, if the first difference value (ΔQa'1) is less than a predetermined first reference value and the second difference value (ΔQb'1) is less than a predetermined second reference value.

For reference, the differential battery bank profile DP1 may provide various diagnostic factors. For example, the voltage value of the first peak (Pa1) among the plurality of peaks (Pa1, Pb1, Pc1, Pd1) of the differential battery bank profile DP1 may be used as a factor for diagnosing the available lithium loss of the corresponding battery bank. In addition, the differential capacity value of the second peak (Pb1) may be used as a factor for diagnosing the positive electrode deterioration state of the corresponding battery bank. In addition, the voltage value of the second peak (Pb1) and the voltage value of the second valley (Vb1) may be used as auxiliary factors for diagnosing the positive electrode deterioration state or the available lithium loss rate.

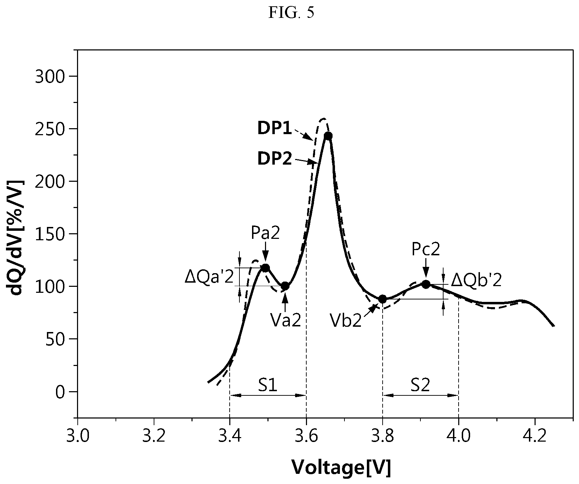

FIG. 5 is a drawing showing the differential battery bank profile DP2 of a battery bank in which uneven deterioration of the battery cells begins.

As shown in FIG. 5, in the differential battery bank profile DP2 of the battery bank in which uneven deterioration of the battery cells begins, the difference value (ΔQa'2) between the differential capacity value of the first target peak (Pa2) and the differential capacity value of the first valley (Va2) is reduced compared to the differential battery bank profile DP1 shown in FIG. 4.

Similarly, in the differential battery bank profile DP2, the difference value (ΔQb'2) between the differential capacity value of the second target peak (Pc2) and the differential capacity value of the second valley (Vb2) is reduced compared to the differential battery bank profile DP1 illustrated in FIG. 4.

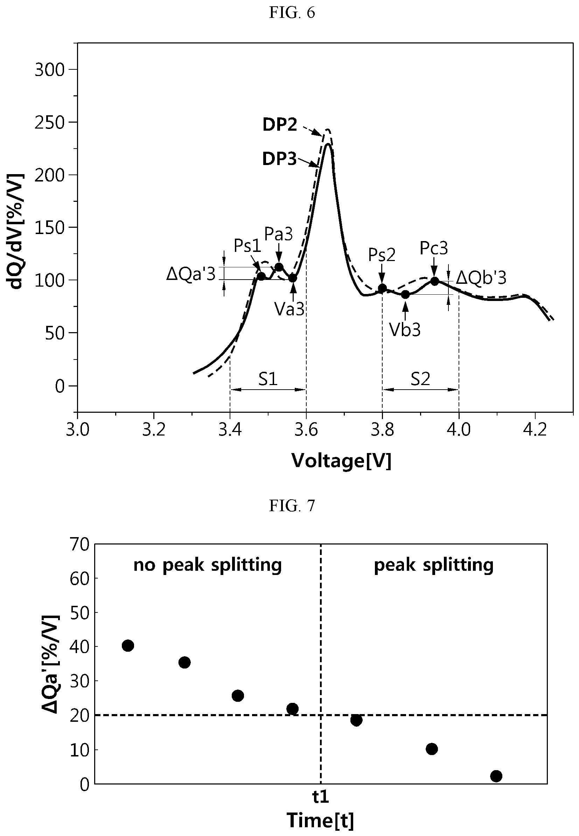

FIG. 6 is a drawing showing a differential battery bank profile DP3 of an abnormal battery bank.

As shown in FIG. 6, in the differential battery bank profile DP3 of an abnormal battery bank in which battery cells are unevenly deteriorated, the first difference value (ΔQa'3) between the differential capacity value of the first target peak (Pa3) and the differential capacity value of the first valley (Va3) is reduced compared to the differential battery bank profile DP2 shown in FIG. 5.

Similarly, in the differential battery bank profile DP3, the second difference value (ΔQb'3) between the differential capacity value of the second target peak (Pc3) and the differential capacity value of the second valley (Vb3) is reduced compared to the differential battery bank profile DP2 illustrated in FIG. 5.

The determination module 114b may determine the state of the battery bank as an abnormal state if the first difference value (ΔQa'3) is less than a predetermined first reference value and the second difference value (ΔQb'3) is less than a predetermined second reference value. In this case, the abnormal state may mean a state in which a plurality of battery cells forming the battery bank are unevenly deteriorated.

In particular, additional peaks (Ps1, Ps2) may occur around the first target peak (Pa3) and the second target peak (Pc3) of the differential battery bank profile DP3 generated after use of the battery assembly due to peak splitting phenomenon caused by uneven deterioration of the battery bank.

Accordingly, the diagnosing unit 114 may be configured to diagnose the state of the battery bank as an abnormal state if the first difference value (ΔQa'3) is less than a predetermined first reference value, the second difference value (ΔQb'3) is less than a predetermined reference value, and the number of target peaks located in the predetermined voltage section (S1, S2) exceeds a predetermined reference number. In this case, the abnormal state may mean a state in which a plurality of battery cells forming the battery bank are unevenly deteriorated.

FIG. 7 is a graph showing the trend of a difference value (ΔQa') between a differential capacity of the first target peak (Pa1) and a differential capacity of the first valley (Va1), as shown in FIG. 4, changing over time (t).

As shown in FIG. 7, if the battery cells of the battery bank are deteriorated unevenly, the difference value (ΔQa') between the differential capacity of the first target peak (Pa1) and the differential capacity of first valley (Va1) located in the first voltage section (S1) of the differential battery bank profile DP1 decreases over time.

In addition, if it reaches a point (t1) at which the difference value (ΔQa') becomes smaller than the first reference value (e.g., 20 [%/V]), a peak splitting phenomenon may occur in the first target peak (Pa1).

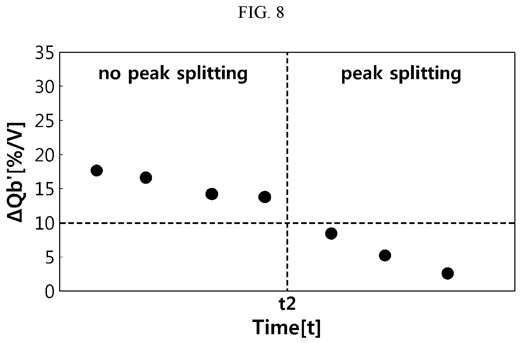

FIG. 8 is a graph showing the trend of a differential capacity difference value ΔQb') between a differential capacity of a second target peak (Pc1) and a differential capacity of a second valley (Vb 1), as shown in FIG. 4, changing over time (t).

As illustrated in FIG. 8, if the battery cells of the battery bank are deteriorated unevenly, the differential capacity difference value (ΔQb') between the second target peak (Pc1) and the second valley (Vb 1) located in the second voltage section (S2) of the differential battery bank profile DP1 decreases over time.

In addition, if it reaches a point (t2) at which the difference value (ΔQb') becomes smaller than the second reference value (e.g., 10 [%/V]), a peak splitting phenomenon may occur in the second target peak (Pc1).

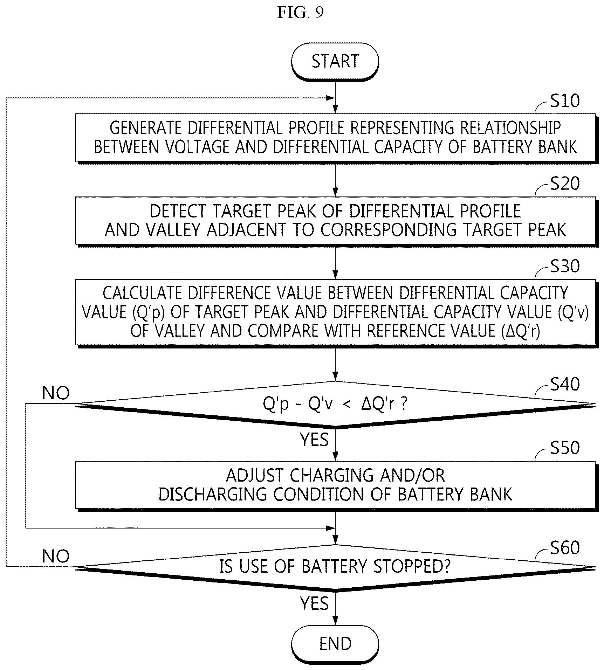

FIG. 9 is a flow chart showing a method for diagnosing a battery according to an embodiment of the present disclosure.

As illustrated in FIG. 9, the method for diagnosing a battery according to the present disclosure is a method for non-destructively diagnosing a battery assembly including one or more battery banks. The one or more battery banks are provided by connecting a plurality of battery cells in parallel with each other. The method may be performed by a processor.

First, the processor generates a differential battery bank profile representing the relationship between a differential capacity and the voltage of the battery bank (S10). The differential capacity may be obtained by differentiating the capacity of the battery bank included in the battery assembly with respect to the voltage of the battery bank.

In this case, the processor may repeatedly measure the voltage value and current value of the battery bank using at least one electrical sensor while the battery bank is being charged or discharged.

Then, the processor may generate a battery bank profile representing the correspondence relationship between voltage and capacity of the battery bank using the voltage values and current values measured while the battery bank is being charged or discharged.

Then, the processor may generate the differential battery bank profile by differentiating the generated battery bank profile with respect to the voltage of the battery bank.

Next, the processor may detect a target peak located in a predetermined voltage section among a plurality of peaks of the differential battery bank profile and a valley adjacent to the target peak (S20). The voltage section where the target peak is located may be determined experimentally. That is, the voltage section in which a peak where splitting occurs due to uneven deterioration of the battery bank among the peaks of the differential battery bank profile is located may be confirmed experimentally, and the confirmed voltage section may be determined as the voltage section where the target peak is located.

Next, the processor diagnoses the state of the battery bank based on the difference value (Q'p - Q'v) between the differential capacity value (Q'p) of the target peak and the differential capacity value (Q'v) of the neighboring valley (S30).

The difference value (Q'p - Q'v) is compared with a predetermined reference value (ΔQ'r). If the difference value (Q'p - Q'v) is smaller than the reference value (ΔQ'r), the processor may diagnose the state of the battery bank as an abnormal state (S40). The abnormal state may mean a state in which a plurality of battery cells forming the battery bank are unevenly deteriorated.

For reference, the reference value (ΔQ'r) may be a difference value between a differential capacity of a target peak and a differential capacity of a neighboring valley detected from a reference differential battery bank profile. The reference differential battery bank profile may be generated at the BOL (Beginning of Life) point of the corresponding battery bank. Alternatively, the reference value (ΔQ'r) may be a difference value determined during the design of the battery assembly.

In an embodiment, the processor may be configured to diagnose the state of the battery bank as an abnormal state if the difference value (Q'p - Q'v) is less than a predetermined reference value (ΔQ'r) and the number of target peaks located in the predetermined voltage section exceeds a predetermined number. The predetermined number may be for example one. In this case, the abnormal state may mean a state in which a plurality of battery cells forming the battery bank are unevenly deteriorated.

In another embodiment, the processor may determine the state of the battery bank based on a plurality of target peaks.

In this case, the processor may calculate a first difference value between a differential capacity value of a first target peak located in a first voltage section among the predetermined voltage sections and a differential capacity value of a first valley adj acent to the first target peak, and calculate a second difference value between a differential capacity value of a second target peak located in a second voltage section among the predetermined voltage sections and a differential capacity value of a second valley adjacent to the second target peak.

Further, the processor may determine the state of the battery bank as an abnormal state in which a plurality of battery cells of the battery bank are unevenly deteriorated, if the first difference value is less than a predetermined first reference value and/or the second difference value is less than a predetermined second reference value.

In an embodiment, when the battery assembly to be diagnosed includes a plurality of battery banks, the processor may be configured to generate a plurality of differential battery bank profiles respectively corresponding to the plurality of battery banks.

In addition, the processor may be configured to diagnose the state of each of the plurality of battery banks as a normal state or an abnormal state based on the plurality of differential battery bank profiles.

Further, the processor may adjust the charging condition and/or discharging condition of the battery bank according to the diagnosis result of the battery bank (S50).

For example, when an abnormal battery bank diagnosed as an abnormal state is detected among the plurality of battery banks included in the battery assembly, the processor may be configured to control a charger that charges the abnormal battery bank to reduce a voltage at the end of charging of the abnormal battery bank or reduce a current rate of a current that charges the abnormal battery bank.

Also, the processor may be configured to control the cooling device 18 described later to lower the temperature of the abnormal battery bank.

Meanwhile, the processor may output a visual, auditory or audio-visual notification signal corresponding to the diagnosis result of the battery bank using a predetermined output device.

Then, the processor may repeat the steps described above (S10 to S50) until the battery assembly is no longer in use (S60).

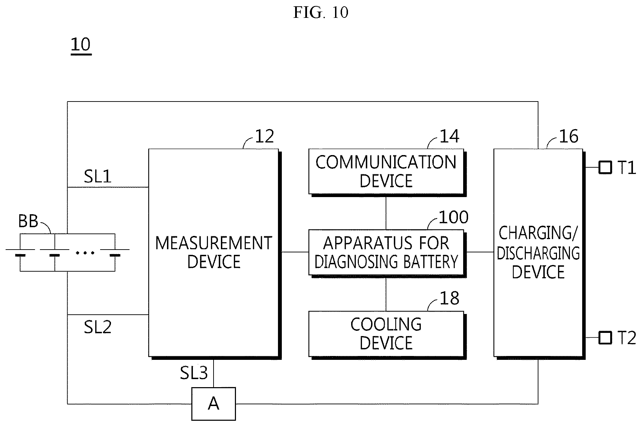

FIG. 10 is a drawing showing a battery pack 10 according to an embodiment of the present disclosure.

As illustrated in FIG. 10, the battery pack 10 includes a battery bank BB provided by connecting a plurality of battery cells in parallel with each other, and the battery diagnosis apparatus 100 according to the present disclosure. In an embodiment, the battery pack 10 may optionally further include a measurement device 12, a communication device 14, a charging/discharging device 16, and a cooling device 18.

The measurement device 12 may be configured to measure the voltage and/or current of the battery bank BB. To this end, the measurement device 12 may include at least one voltage sensor for sensing the voltage of the battery bank BB and/or at least one current sensor for sensing the current of the battery bank BB.

The measurement device 12 may measure the voltage of the battery bank BB through the first sensing line SL1 and the second sensing line SL2. The first sensing line SL1 and the second sensing line SL2 may be connected to the positive electrode and negative electrode of the battery bank BB. In addition, the measurement device 12 may measure the current of the battery bank BB through the third sensing line SL3 connected to the current measurement circuit A. The current measurement circuit A may include a shunt resistor. The current measurement circuit A is in the current path between the positive electrode and negative electrode of the battery bank BB.

The battery diagnosis apparatus 100 according to an embodiment of the present disclosure may obtain voltage values of the battery bank BB through the measurement device 12. The battery diagnosis apparatus 100 may also obtain current values of the battery bank BB through the measurement device 12. For example, the capacity of the battery bank BB may be calculated by applying the current integration method.

The communication device 14 may be configured to perform communication with another device located remotely. For example, the communication device 14 may be configured to receive data transmitted from a remote server or communication terminal through a wired and/or wireless communication network and transmit the data to the battery diagnosis apparatus 100, or transmit data generated in the battery diagnosis apparatus 100 to another server or communication terminal. To this end, the communication device 14 may include a communication modem that performs wired communication and/or wireless communication.

The charging/discharging device 16 may be configured to charge and/or discharge the battery bank BB. To this end, the charging/discharging device 16 may include a charger for charging the battery bank BB, a discharger for discharging the battery bank BB, at least one switch for electrically connecting the battery bank BB to terminals T1, T2 of the battery pack 10, etc.

The battery diagnosis apparatus 100 according to an embodiment of the present disclosure may control the charging/discharging device 16 to perform charging or discharging or stop charging or discharging of the battery bank BB, set charging/discharging conditions (e.g., C-rate), or change the set charging/discharging conditions.

The cooling device 18 may be configured to cool the battery bank BB. To this end, the cooling device 18 may include a heat sink that absorbs heat from the battery bank BB and releases it to the outside.

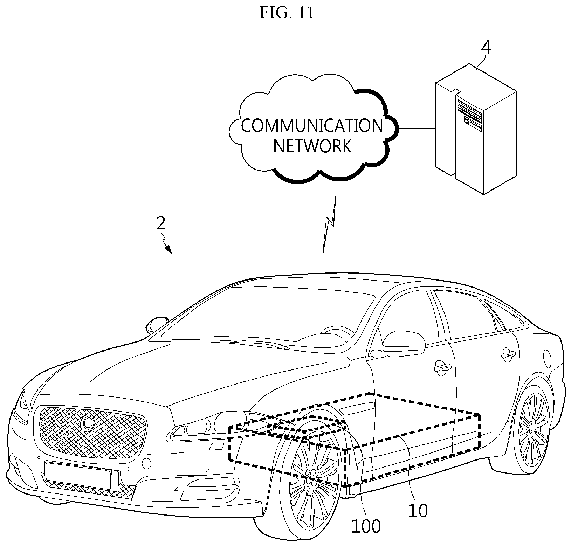

FIG. 11 is a drawing showing a vehicle according to an embodiment of the present disclosure.

As illustrated in FIG. 11, the vehicle 2 according to an embodiment of the present disclosure may include a battery pack 10 that provides electrical energy necessary for the operation of the vehicle and the battery diagnosis apparatus 100 according to the present disclosure.

In this case, the battery diagnosis apparatus 100 may be configured to interact with an ECU (Electronic Control Unit) that controls the operation of the vehicle 2 or a BMS (Battery Management System) of the battery pack 10.

Additionally, the battery diagnosis apparatus 100 may be configured to receive data transmitted from a remote server 4 via a wired and/or wireless communication network, or to transmit data generated by the battery diagnosis apparatus 100 to the server 4.

For reference, the battery diagnosis apparatus 100 according to the present disclosure may be applied to various electrical devices or electrical systems other than vehicles, as well as to ESS (Energy Storage System).

As described above, the present disclosure diagnoses the state of the battery bank by using the differential profile, which represents the correspondence relationship between the differential capacity, which is obtained by differentiating the capacity of the battery bank with respect to the voltage of the battery bank, and the voltage of the battery bank, thereby enabling the diagnosis of the state of the battery assembly including a plurality of battery banks for each battery bank, and improving the accuracy and reliability of the diagnosis result.

In addition, the present disclosure may accurately diagnose whether the battery cells are deteriorated unevenly in a battery bank that is formed by connecting the battery cells in parallel by diagnosing the state of the battery bank based on the difference value between the differential capacity value of a target peak located in a predetermined voltage section among a plurality of peaks of the differential battery bank profile and the differential capacity value of a valley adjacent to the target peak.

In addition, the present disclosure may perform management of a battery assembly including a plurality of battery banks for each battery bank by controlling the charge and/or discharge conditions of the corresponding battery bank according to the diagnosis result of the battery bank, thereby extending the life of the entire battery assembly and improving safety.

Furthermore, the embodiments according to the present disclosure may solve various technical problems other than those mentioned in this specification in the corresponding technical field as well as in related technical fields.

The present disclosure has been described with reference to specific embodiments. However, those skilled in the art will clearly understand that various modified embodiments can be implemented within the technical scope of the present disclosure. Therefore, the embodiments disclosed above should be considered from an illustrative rather than a restrictive perspective. The invention is set out in the appended set of claims.

### [Explanation of reference signs]

2: vehicle
10: battery pack
100: apparatus for diagnosing a battery
110: control unit
112: differential profile generating unit
114: diagnosing unit
116: diagnosis result informing unit
118: battery management unit
120: communication unit
130: input unit
140: storage unit
150: output unit

## Claims

1. A method for diagnosing a battery assembly including a battery bank, wherein the battery bank is provided by connecting a plurality of battery cells in parallel with each other, the method comprising:
a differential profile generating step (S10) of generating a differential battery bank profile representing a relationship between a differential capacity and the voltage of the battery bank, wherein the differential capacity is obtained by differentiating a capacity of the battery bank with respect to a voltage of the battery bank; the method is **characterised by**
a diagnosing step (S20) of diagnosing a state of the battery bank based on a difference value between a differential capacity value of a target peak located in a predetermined voltage section among a plurality of peaks of the differential battery bank profile and a differential capacity value of a valley adjacent to the target peak.

2. The method for diagnosing a battery according to claim 1, wherein the differential profile generating step includes:
a step of repeatedly measuring a voltage value and a current value of the battery bank using at least one electrical sensor while the battery bank is being charged or discharged; and
a step of generating the differential battery bank profile using the voltage values and the current values measured while the battery bank is being charged or discharged.

3. The method for diagnosing a battery according to claim 1 or 2, wherein the differential profile generating step includes:
a step of generating a battery bank profile representing a relationship between the voltage and the capacity of the battery bank; and
a step of generating the differential battery bank profile by differentiating the battery bank profile with respect to the voltage of the battery bank.

4. The method for diagnosing a battery according to one of claims 1 to 3, wherein the diagnosing step includes a step of diagnosing the state of the battery bank as an abnormal state when the difference value is less than a predetermined reference value.

5. The method for diagnosing a battery according to one of claims 1 to 4, wherein the diagnosing step includes a step of diagnosing the state of the battery bank as an abnormal state in which the plurality of battery cells are unevenly deteriorated, when the difference value is less than a predetermined reference value and the number of target peaks located in the predetermined voltage section exceeds a predetermined reference number.

6. The method for diagnosing a battery according to one of claims 1 to 5, wherein the diagnosing step includes:
a step of calculating a first difference value between a differential capacity value of a first target peak located in a first voltage section among the predetermined voltage sections and a differential capacity value of a first valley adjacent to the first target peak;
a step of calculating a second difference value between a differential capacity value of a second target peak located in a second voltage section among the predetermined voltage sections and a differential capacity value of a second valley adjacent to the second target peak; and
a step of determining the state of the battery bank as an abnormal state in which the plurality of battery cells are unevenly deteriorated, when the first difference value is less than a predetermined first reference value and the second difference value is less than a predetermined second reference value.

7. The method for diagnosing a battery according to one of claims 1 to 6, wherein the battery assembly includes a plurality of battery banks,
wherein the differential profile generating step includes a step of generating a plurality of differential battery bank profiles respectively corresponding to the plurality of battery banks, and
wherein the diagnosing step includes a step of diagnosing a state of each of the plurality of battery banks as a normal state or an abnormal state based on the plurality of differential battery bank profiles.

8. The method for diagnosing a battery according to one of claims 1 to 7, wherein the diagnosing step includes a step of diagnosing the state of the battery bank as an abnormal state when the difference value is less than a predetermined reference value, and
wherein the method for diagnosing a battery further comprises a step of controlling a charger that charges the battery bank to reduce a voltage at an end of charging of the battery bank or reduce a current rate of a current that charges the battery bank, when the state of the battery bank is diagnosed as an abnormal state.

9. A battery diagnosis apparatus for diagnosing a battery assembly, the battery assembly including a battery bank in which a plurality of battery cells are connected in parallel with each other, the apparatus comprising:
a differential profile generating unit (112) configured to generate a differential battery bank profile representing a relationship between a differential capacity, which is obtained by differentiating a capacity of the battery bank with respect to a voltage of the battery bank, and the voltage of the battery bank; the apparatus is **characterised by** further comprising
a diagnosing unit (114) configured to diagnose a state of the battery bank based on a difference value between a differential capacity value of a target peak located in a predetermined voltage section among a plurality of peaks of the differential battery bank profile and a differential capacity value of a valley adjacent to the target peak.

10. The apparatus for diagnosing a battery according to claim 9, wherein the diagnosing unit is configured to diagnose the state of the battery bank as an abnormal state when the difference value is less than a predetermined reference value.

11. The apparatus for diagnosing a battery according to claim 9 or 10, wherein the diagnosing unit includes:
a calculation module (114a) configured to calculate a first difference value between a differential capacity value of a first target peak located in a first voltage section among the predetermined voltage sections and a differential capacity value of a first valley adjacent to the first target peak and calculate a second difference value between a differential capacity value of a second target peak located in a second voltage section among the predetermined voltage sections and a differential capacity value of a second valley adjacent to the second target peak; and
a determination module (114b) configured to determine the state of the battery bank as an abnormal state in which the plurality of battery cells are unevenly deteriorated, when the first difference value is less than a predetermined first reference value and the second difference value is less than a predetermined second reference value.

12. The apparatus for diagnosing a battery according to one of claims 9 to 11, wherein the battery assembly includes a plurality of battery banks,
wherein the differential profile generating unit is configured to generate a plurality of differential battery bank profiles respectively corresponding to the plurality of battery banks, and
wherein the diagnosing unit is configured to diagnose a state of each of the plurality of battery banks as a normal state or an abnormal state based on the plurality of differential battery bank profiles.

13. The apparatus for diagnosing a battery according to one of claims 9 to 12,
wherein the diagnosing unit is configured to diagnose the state of the battery bank as an abnormal state when the difference value is less than a predetermined reference value, and
wherein the apparatus for diagnosing a battery further comprises a battery management unit (118) configured to control a charger that charges the battery bank to reduce a voltage at an end of charging of the battery bank or reduce a current rate of a current that charges the battery bank, when the state of the battery bank is diagnosed as an abnormal state.

14. A battery pack comprising the apparatus for diagnosing a battery according to any one of claims 9 to 13.

15. A vehicle comprising the apparatus for diagnosing a battery according to any one of claims 9 to 13.

## Patentansprüche

1. Verfahren zum Diagnostizieren einer Batterieanordnung, die eine Batteriebank enthält, wobei die Batteriebank durch paralleles Verbinden mehrerer Batteriezellen miteinander bereitgestellt wird, wobei das Verfahren Folgendes umfasst:
einen Schritt zum Erzeugen eines Differenzialprofils (S10), in dem ein Differenzial-Batteriebankprofil erzeugt wird, das eine Beziehung zwischen einer Differenzialkapazität und der Spannung der Batteriebank darstellt, wobei die Differenzialkapazität durch Differenzieren einer Kapazität der Batteriebank nach einer Spannung der Batteriebank erhalten wird; wobei das Verfahren **gekennzeichnet ist durch**
einen Diagnoseschritt (S20), in dem ein Zustand der Batteriebank auf der Grundlage eines Differenzwerts zwischen einem Differenzialkapazitätswert eines Zielpeaks, der in einem vorbestimmten Spannungsabschnitt unter einer Mehrzahl von Peaks des Differenzial-Batteriebankprofils liegt, und einem Differenzialkapazitätswert eines an den Zielpeak angrenzenden Tals diagnostiziert wird.

2. Verfahren zum Diagnostizieren einer Batterie nach Anspruch 1, wobei der Schritt zum Erzeugen eines Differenzialprofils Folgendes enthält:
einen Schritt, in dem ein Spannungswert und ein Stromwert der Batteriebank unter Verwendung von mindestens einem elektrischen Sensor wiederholt gemessen werden, während die Batteriebank geladen oder entladen wird; und
einen Schritt, in dem das Differenzial-Batteriebankprofil unter Verwendung der Spannungswerte und der Stromwerte erzeugt wird, die gemessen wurden, während die Batteriebank geladen oder entladen wird.

3. Verfahren zum Diagnostizieren einer Batterie nach Anspruch 1 oder 2, wobei der Schritt zum Erzeugen eines Differenzialprofils Folgendes enthält:
einen Schritt, in dem ein Batteriebankprofil erzeugt wird, das eine Beziehung zwischen der Spannung und der Kapazität der Batteriebank darstellt; und
einen Schritt, in dem das Differenzial-Batteriebankprofil erzeugt wird, indem das Batteriebankprofil nach der Spannung der Batteriebank differenziert wird.

4. Verfahren zum Diagnostizieren einer Batterie nach einem der Ansprüche 1 bis 3, wobei der Diagnoseschritt einen Schritt umfasst, in dem der Zustand der Batteriebank als ein anormaler Zustand diagnostiziert wird, wenn der Differenzwert kleiner als ein vorbestimmter Referenzwert ist.

5. Verfahren zum Diagnostizieren einer Batterie nach einem der Ansprüche 1 bis 4, wobei der Diagnoseschritt einen Schritt umfasst, in dem der Zustand der Batteriebank als ein anormaler Zustand diagnostiziert wird, in dem die Mehrzahl von Batteriezellen ungleichmäßig verschlechtert ist, wenn der Differenzwert kleiner als ein vorbestimmter Referenzwert ist und die Anzahl von Zielpeaks, die in dem vorbestimmten Spannungsabschnitt liegen, eine vorbestimmte Referenzanzahl überschreitet.

6. Verfahren zum Diagnostizieren einer Batterie nach einem der Ansprüche 1 bis 5, wobei der Diagnoseschritt Folgendes enthält:
einen Schritt, in dem ein erster Differenzwert zwischen einem Differenzialkapazitätswert eines ersten Zielpeaks, der in einem ersten Spannungsabschnitt unter den vorbestimmten Spannungsabschnitten liegt, und einem Differenzialkapazitätswert eines ersten an den ersten Zielpeak angrenzenden Tals berechnet wird;
einen Schritt, in dem ein zweiter Differenzwert zwischen einem Differenzialkapazitätswert eines zweiten Zielpeaks, der in einem zweiten Spannungsabschnitt unter den vorbestimmten Spannungsabschnitten liegt, und einem Differenzialkapazitätswert eines zweiten an den zweiten Zielpeak angrenzenden Tals berechnet wird; und
einen Schritt, in dem der Zustand der Batteriebank als ein anormaler Zustand bestimmt wird, in dem die Mehrzahl von Batteriezellen ungleichmäßig verschlechtert ist, wenn der erste Differenzwert kleiner als ein vorbestimmter erster Referenzwert ist und der zweite Differenzwert kleiner als ein vorbestimmter zweiter Referenzwert ist.

7. Verfahren zum Diagnostizieren einer Batterie nach einem der Ansprüche 1 bis 6, wobei die Batterieanordnung mehrere Batteriebänke umfasst,
wobei der Differenzialprofilerzeugungsschritt einen Schritt umfasst, in dem eine Mehrzahl von Differenzial-Batteriebankprofilen erzeugt wird, die jeweils der Mehrzahl von Batteriebänken entsprechen, und
wobei der Diagnoseschritt einen Schritt umfasst, in dem ein Zustand jeder der Mehrzahl von Batteriebänken auf der Grundlage der Mehrzahl von Differenzial-Batteriebankprofilen als ein normaler Zustand oder ein anormaler Zustand diagnostiziert wird.

8. Verfahren zum Diagnostizieren einer Batterie nach einem der Ansprüche 1 bis 7, wobei der Diagnoseschritt einen Schritt umfasst, in dem der Zustand der Batteriebank als ein anormaler Zustand diagnostiziert wird, wenn der Differenzwert kleiner als ein vorbestimmter Referenzwert ist, und
wobei das Verfahren zum Diagnostizieren einer Batterie ferner einen Schritt umfasst, in dem ein Ladegerät, das die Batteriebank lädt, gesteuert wird, um eine Spannung an einem Ende des Ladens der Batteriebank zu reduzieren oder eine Stromrate eines Stroms, der die Batteriebank lädt, zu reduzieren, wenn der Zustand der Batteriebank als ein anormaler Zustand diagnostiziert wird.

9. Batteriediagnosevorrichtung zum Diagnostizieren einer Batterieanordnung, wobei die Batterieanordnung eine Batteriebank enthält, in der mehrere Batteriezellen parallel miteinander verbunden sind, wobei die Vorrichtung Folgendes umfasst:
eine Einheit zum Erzeugen eines Differenzialprofils (112), die konfiguriert ist, um ein Differenzial-Batteriebankprofil zu erzeugen, das eine Beziehung zwischen einer Differenzialkapazität, die durch Differenzieren einer Kapazität der Batteriebank nach einer Spannung der Batteriebank erhalten wird, und der Spannung der Batteriebank darstellt; wobei die Vorrichtung **dadurch gekennzeichnet ist, dass** sie ferner Folgendes umfasst:
eine Diagnoseeinheit (114), die konfiguriert ist, um einen Zustand der Batteriebank auf der Grundlage eines Differenzwerts zwischen einem Differenzialkapazitätswert eines Zielpeaks, der in einem vorbestimmten Spannungsabschnitt unter einer Mehrzahl von Peaks des Differenzial-Batteriebankprofils liegt, und einem Differenzialkapazitätswert eines an den Zielpeak angrenzenden Tals zu diagnostizieren.

10. Vorrichtung zum Diagnostizieren einer Batterie nach Anspruch 9, wobei die Diagnoseeinheit konfiguriert ist, um den Zustand der Batteriebank als einen anormalen Zustand zu diagnostizieren, wenn der Differenzwert kleiner als ein vorbestimmter Referenzwert ist.

11. Vorrichtung zum Diagnostizieren einer Batterie nach Anspruch 9 oder 10, wobei die Diagnoseeinheit Folgendes enthält:
ein Berechnungsmodul (114a), das konfiguriert ist, um einen ersten Differenzwert zwischen einem Differenzialkapazitätswert eines ersten Zielpeaks, der in einem ersten Spannungsabschnitt unter den vorbestimmten Spannungsabschnitten liegt, und einem Differenzialkapazitätswert eines ersten an den ersten Zielpeak angrenzenden Tals zu berechnen und einen zweiten Differenzwert zwischen einem Differenzialkapazitätswert eines zweiten Zielpeaks, der in einem zweiten Spannungsabschnitt unter den vorbestimmten Spannungsabschnitten liegt, und einem Differenzialkapazitätswert eines zweiten an den zweiten Zielpeak angrenzenden Tals zu berechnen; und
ein Bestimmungsmodul (114b), das konfiguriert ist, um den Zustand der Batteriebank als einen anormalen Zustand zu bestimmen, in dem die Mehrzahl von Batteriezellen ungleichmäßig verschlechtert ist, wenn der erste Differenzwert kleiner als ein vorbestimmter erster Referenzwert ist und der zweite Differenzwert kleiner als ein vorbestimmter zweiter Referenzwert ist.

12. Vorrichtung zum Diagnostizieren einer Batterie nach einem der Ansprüche 9 bis 11, wobei die Batterieanordnung mehrere Batteriebänke enthält,
wobei die Einheit zum Erzeugen eines Differenzialprofils konfiguriert ist, um eine Mehrzahl von Differenzial-Batteriebankprofilen zu erzeugen, die jeweils der Mehrzahl von Batteriebänken entsprechen, und
wobei die Diagnoseeinheit konfiguriert ist, um einen Zustand jeder der Mehrzahl von Batteriebänken auf der Grundlage der Mehrzahl von Differenzial-Batteriebankprofilen als einen normalen Zustand oder einen anormalen Zustand zu diagnostizieren.

13. Vorrichtung zum Diagnostizieren einer Batterie nach einem der Ansprüche 9 bis 12,
wobei die Diagnoseeinheit konfiguriert ist, um den Zustand der Batteriebank als einen anormalen Zustand zu diagnostizieren, wenn der Differenzwert kleiner als ein vorbestimmter Referenzwert ist, und
wobei die Vorrichtung zum Diagnostizieren einer Batterie ferner eine Batterieverwaltungseinheit (118) umfasst, die konfiguriert ist, um ein Ladegerät, das die Batteriebank lädt, zu steuern, um eine Spannung an einem Ende des Ladens der Batteriebank zu reduzieren oder eine Stromrate eines Stroms, der die Batteriebank lädt, zu reduzieren, wenn der Zustand der Batteriebank als ein anormaler Zustand diagnostiziert wird.

14. Batteriepack, umfassend die Vorrichtung zum Diagnostizieren einer Batterie nach einem der Ansprüche 9 bis 13.

15. Fahrzeug, umfassend die Vorrichtung zum Diagnostizieren einer Batterie nach einem der Ansprüche 9 bis 13.

## Revendications

1. Procédé servant à diagnostiquer un ensemble formant batterie comprenant un banc de batteries, dans lequel le banc de batteries est mis en œuvre en connectant une pluralité d'éléments de batterie en parallèle les uns avec les autres, le procédé comportant :
une étape de génération de profil différentiel (S10) consistant à générer un profil différentiel de banc de batteries représentant une relation entre une capacité différentielle et la tension du banc de batteries, dans lequel la capacité différentielle est obtenue par la différentiation d'une capacité du banc de batteries par rapport à une tension du banc de batteries ; le procédé est **caractérisé par**
une étape de diagnostic (S20) consistant à diagnostiquer un état du banc de batteries sur la base d'une valeur de différence entre une valeur de capacité différentielle d'une crête cible se trouvant dans une section de tension prédéterminée parmi une pluralité de crêtes du profil différentiel de banc de batteries et une valeur de capacité différentielle d'un creux adjacent à la crête cible.

2. Procédé servant à diagnostiquer une batterie selon la revendication 1, dans lequel l'étape de génération de profil différentiel comprend :
une étape consistant à mesurer de manière répétée une valeur de tension et une valeur de courant du banc de batteries en utilisant au moins un capteur électrique pendant que le banc de batteries est en cours de charge ou de décharge ; et
une étape consistant à générer le profil différentiel de banc de batteries en utilisant les valeurs de tension et les valeurs de courant mesurées pendant que le banc de batteries est en cours de charge ou de décharge.

3. Procédé servant à diagnostiquer une batterie selon la revendication 1 ou la revendication 2, dans lequel l'étape de génération de profil différentiel comprend :
une étape consistant à générer un profil de banc de batteries représentant une relation entre la tension et la capacité du banc de batteries ; et
une étape consistant à générer le profil différentiel de banc de batteries par la différentiation du profil de banc de batteries par rapport à la tension du banc de batteries.

4. Procédé servant à diagnostiquer une batterie selon l'une des revendications 1 à 3, dans lequel l'étape de diagnostic comprend une étape consistant à diagnostiquer l'état du banc de batteries comme étant un état anormal quand la valeur de différence est inférieure à une valeur de référence prédéterminée.

5. Procédé servant à diagnostiquer une batterie selon l'une des revendications 1 à 4, dans lequel l'étape de diagnostic comprend une étape consistant à diagnostiquer l'état du banc de batteries comme étant un état anormal dans lequel les éléments de la pluralité d'éléments de batterie sont détériorés de manière inégale, quand la valeur de différence est inférieure à une valeur de référence prédéterminée et quand le nombre de crêtes cibles se trouvant dans la section de tension prédéterminée dépasse un nombre de référence prédéterminé.

6. Procédé servant à diagnostiquer une batterie selon l'une des revendications 1 à 5, dans lequel l'étape de diagnostic comprend :
une étape consistant à calculer une première valeur de différence entre une valeur de capacité différentielle d'une première crête cible se trouvant dans une première section de tension parmi les sections de tension prédéterminées et une valeur de capacité différentielle d'un premier creux adjacent à la première crête cible ;
une étape consistant à calculer une deuxième valeur de différence entre une valeur de capacité différentielle d'une deuxième crête cible se trouvant dans une deuxième section de tension parmi les sections de tension prédéterminées et une valeur de capacité différentielle d'un deuxième creux adjacent à la deuxième crête cible ; et
une étape consistant à déterminer l'état du banc de batteries comme étant un état anormal dans lequel les éléments de la pluralité d'éléments de batterie sont détériorés de manière inégale, quand la première valeur de différence est inférieure à une première valeur de référence prédéterminée et quand la deuxième valeur de différence est inférieure à une deuxième valeur de référence prédéterminée.

7. Procédé servant à diagnostiquer une batterie selon l'une des revendications 1 à 6, dans lequel l'ensemble formant batterie comprend une pluralité de bancs de batteries,
dans lequel l'étape de génération de profil différentiel comprend une étape consistant à générer une pluralité de profils différentiels de bancs de batteries correspondant respectivement à la pluralité de bancs de batteries, et
dans lequel l'étape de diagnostic comprend une étape consistant à diagnostiquer un état de chaque banc de la pluralité de bancs de batteries comme étant un état normal ou un état anormal sur la base de la pluralité de profils différentiels de bancs de batteries.

8. Procédé servant à diagnostiquer une batterie selon l'une des revendications 1 à 7, dans lequel l'étape de diagnostic comprend une étape consistant à diagnostiquer l'état du banc de batteries comme étant un état anormal quand la valeur de différence est inférieure à une valeur de référence prédéterminée, et
dans lequel le procédé servant à diagnostiquer une batterie comporte par ailleurs une étape consistant à commander un chargeur qui charge le banc de batteries pour réduire une tension lors d'une fin de charge du banc de batteries ou pour réduire un régime en cours d'un courant qui charge le banc de batteries, quand l'état du banc de batteries est diagnostiqué comme étant un état anormal.

9. Appareil de diagnostic de batterie servant à diagnostiquer un ensemble formant batterie, l'ensemble formant batterie comprenant un banc de batteries dans lequel les éléments d'une pluralité d'éléments de batterie sont connectés en parallèle les uns avec les autres, l'appareil comportant :
une unité de génération de profil différentiel (112) configurée pour générer un profil différentiel de banc de batteries représentant une relation entre une capacité différentielle, qui est obtenue par la différentiation d'une capacité du banc de batteries par rapport à une tension du banc de batteries, et la tension du banc de batteries ; l'appareil est **caractérisé en ce qu'**il comporte par ailleurs
une unité de diagnostic (114) configurée pour diagnostiquer un état du banc de batteries sur la base d'une valeur de différence entre une valeur de capacité différentielle d'une crête cible se trouvant dans une section de tension prédéterminée parmi une pluralité de crêtes du profil différentiel de banc de batteries et une valeur de capacité différentielle d'un creux adjacent à la crête cible.

10. Appareil servant à diagnostiquer une batterie selon la revendication 9, dans lequel l'unité de diagnostic est configurée pour diagnostiquer l'état du banc de batteries comme étant un état anormal quand la valeur de différence est inférieure à une valeur de référence prédéterminée.

11. Appareil servant à diagnostiquer une batterie selon la revendication 9 ou la revendication 10, dans lequel l'unité de diagnostic comprend :
un module de calcul (114a) configuré pour calculer une première valeur de différence entre une valeur de capacité différentielle d'une première crête cible se trouvant dans une première section de tension parmi les sections de tension prédéterminées et une valeur de capacité différentielle d'un premier creux adjacent à la première crête cible et pour calculer une deuxième valeur de différence entre une valeur de capacité différentielle d'une deuxième crête cible se trouvant dans une deuxième section de tension parmi les sections de tension prédéterminées et une valeur de capacité différentielle d'un deuxième creux adjacent à la deuxième crête cible ; et
un module de détermination (114b) configuré pour déterminer l'état du banc de batterie comme étant un état anormal dans lequel les éléments de la pluralité d'éléments de batterie sont détériorés de manière inégale, quand la première valeur de différence est inférieure à une première valeur de référence prédéterminée et quand la deuxième valeur de différence est inférieure à une deuxième valeur de référence prédéterminée.

12. Appareil servant à diagnostiquer une batterie selon l'une des revendications 9 à 11, dans lequel l'ensemble formant batterie comprend une pluralité de bancs de batteries,
dans lequel l'unité de génération de profil différentiel est configurée pour générer une pluralité de profils différentiels de bancs de batteries correspondant respectivement à la pluralité de bancs de batteries, et
dans lequel l'unité de diagnostic est configurée pour diagnostiquer un état de chaque banc de la pluralité de bancs de batteries comme étant un état normal ou un état anormal sur la base de la pluralité de profils différentiels de bancs de batteries.

13. Appareil servant à diagnostiquer une batterie selon l'une des revendications 9 à 12,
dans lequel l'unité de diagnostic est configurée pour diagnostiquer l'état du banc de batteries comme étant un état anormal quand la valeur de différence est inférieure à une valeur de référence prédéterminée, et
dans lequel l'appareil servant à diagnostiquer une batterie comporte par ailleurs une unité de gestion de batteries (118) configurée pour commander un chargeur qui charge le banc de batteries pour réduire une tension lors d'une fin de charge du banc de batteries ou pour réduire un régime en cours d'un courant qui charge le banc de batteries, quand l'état du banc de batteries est diagnostiqué comme étant un état anormal.

14. Bloc de batterie, comportant l'appareil servant à diagnostiquer une batterie selon l'une quelconque des revendications 9 à 13.

15. Véhicule comportant l'appareil servant à diagnostiquer une batterie selon l'une quelconque des revendications 9 à 13.
